# FASCICULE DE BREVET EUROPEEN

(11) **EP 3 721 467 B1**
(45) Date de publication et mention de la délivrance du brevet: **29.12.2021**
(21) Numéro de dépôt: 18816207.7
(22) Date de dépôt: 21.11.2018
(51) Int. Cl.: H01L 21/02, H01L 21/762

(54) **PROCÉDÉ DE PRÉPARATION D'UN RÉSIDU DE SUBSTRAT DONNEUR, SUBSTRAT OBTENU À L'ISSU DE CE PROCÉDÉ, ET UTILISATION D'UN TEL SUBSTRAT**
VERFAHREN ZUR HERSTELLUNG DES RESTES EINES DONORSUBSTRATS, NACH DIESEM VERFAHREN HERGESTELLTES SUBSTRAT UND VERWENDUNG EINES SOLCHEN SUBSTRATS
METHOD FOR PREPARING THE REMAINDER OF A DONOR SUBSTRATE, SUBSTRATE PRODUCED BY SAID METHOD, AND USE OF SUCH A SUBSTRATE

(30) Priorité: 05.12.2017 FR 1761674
(43) Date de publication de la demande: 14.10.2020
(73) Titulaire: Soitec, 38190 Bernin (FR)
(72) Inventeur: DRAZEK, Charlotte, 38100 Grenoble (FR); BELHACHEMI, Djamel, 38400 Saint Martin D'heres (FR)
(74) Mandataire: IP Trust
(86) Numéro de dépôt international: PCT/FR2018/052938
(87) Numéro de publication internationale: WO 2019/110885

(56) Documents cités:
- US-A1- 2009 061 545

## Description

### DOMAINE DE L'INVENTION

La présente invention concerne un procédé de préparation d'un résidu de substrat donneur. Les substrats obtenus à l'issue de ce procédé peuvent être utilisés pour former une structure sur isolant du type SOI peu onéreuse, par exemple pour son utilisation dans le domaine de la microélectronique, pour la fabrication de MEMS...

### ARRIERE PLAN TECHNOLOGIQUE DE L'INVENTION

La technologie Smart Cut^{™} est une technologie très employée dans le milieu du semi-conducteur pour la formation d'une couche mince sur un substrat support. Cette technologie permet le prélèvement d'une couche mince sur une face d'un substrat donneur par fracture au niveau d'un plan fragilisé (ou plan de fragilisation) formé par implantation d'espèces légères. Le substrat donneur restant après le transfert de la couche mince est appelé « résidu » et comporte généralement une marche annulaire correspondant à la partie non prélevée de la face du substrat donneur.

La présente invention concerne plus particulièrement la préparation d'un tel résidu pour le rendre réutilisable. On connaît de tels procédés de préparation d'un résidu obtenu à l'issue du procédé Smart Cut^{™}. A titre d'exemple, on peut citer les documents US20090061545, US20100200854. Ces procédés sont généralement complexes et comprennent le retrait de la marche annulaire. Une méthode classique de l'état de l'art comporte les étapes suivantes : un premier polissage pour retirer en partie la marche annulaire du résidu, puis un « double-sided polishing » (polissage simultané des deux faces), suivi d'un polissage chimique afin de totalement retirer la marche et d'obtenir une surface aux propriétés de surface satisfaisantes pour une utilisation ultérieure. Ces méthodes peuvent aussi comprendre d'autres étapes additionnelles telle qu'une désoxydation.

Les méthodes de l'état de la technique sont souvent coûteuses, longues et peuvent entraîner une perte de matière importante notamment pour les méthodes à base de « double-sided polishing ». Suivant l'utilisation ultérieure qui sera faite du résidu, il peut être intéressant de réduire cette perte de matières.

### OBJET DE L'INVENTION

Un but de l'invention est de proposer un procédé de préparation d'un résidu de substrat donneur, adressant en partie au moins le problème précité. Elle vise notamment un procédé de préparation plus simple, moins cher et engendrant moins de perte de matière que ceux de l'état de la technique.

### BREVE DESCRIPTION DE L'INVENTION

En vue de la réalisation de ce but, l'objet de l'invention propose un procédé de préparation du résidu d'un substrat donneur, le substrat donneur ayant subi un prélèvement d'une couche par délamination au niveau d'un plan fragilisé par implantation ionique, le résidu comprenant sur une face principale une marche annulaire correspondant à une partie non prélevée du substrat donneur, le procédé comprenant un dépôt d'un oxyde lissant sur la face principale du résidu pour combler l'espace interne défini par la marche annulaire et recouvrir au moins en partie la marche annulaire ainsi qu'un traitement thermique de densification de l'oxyde lissant.

Selon d'autres caractéristiques avantageuses et non limitatives de l'invention, prises seules ou selon toute combinaison techniquement réalisable :
- l'oxyde lissant appartient à la famille des SOG (Spin On Glass) ;
- le traitement thermique de densification présente une température comprise entre 225 et 900 °C ;
- le traitement thermique de densification est réalisé sous une atmosphère d'azote (N2) ;
- le dépôt d'oxyde lissant est réalisé dans des conditions conduisant à former une couche présentant une épaisseur au moins égale à une fois et demie la hauteur de la marche annulaire ;
- le procédé comporte une étape de préparation de la surface principale du résidu, avant l'étape de dépôt ;
- l'étape de préparation de la surface principale comprend le retrait d'une zone périphérique de la surface principale endommagée par l'implantation ionique.

L'invention porte aussi sur un substrat comprenant un résidu d'un substrat donneur, le substrat donneur ayant subi un prélèvement d'une couche par délamination au niveau d'un plan fragilisé par implantation ionique, le résidu comprenant sur une face principale une marche annulaire correspondant à une partie non prélevée du substrat donneur, le substrat comprenant aussi une couche d'oxyde sur la face principale du résidu, la couche d'oxyde comblant l'espace interne défini par la marche annulaire et recouvrant au moins en partie la marche annulaire.

Selon d'autres caractéristiques avantageuses et non limitatives de l'invention, prises seules ou selon toute combinaison techniquement réalisable :
- la couche d'oxyde présente une épaisseur au moins égale à une fois et demie la hauteur de la marche annulaire ;
- le résidu comprend une couche d'oxyde superficielle ;
- le substrat donneur est constitué de silicium.

L'invention porte aussi sur l'utilisation d'un substrat, comprenant la fourniture d'un substrat préparé comme précisé précédemment, son assemblage avec un substrat donneur et l'amincissement du substrat donneur pour former une structure sur isolant (par exemple du type SOI, Silicon on Insulator).

L'assemblage peut comprendre un traitement thermique à une température comprise entre 100°C et 500°C.

### BREVE DESCRIPTION DES DESSINS

D'autres caractéristiques et avantages de l'invention ressortiront de la description détaillée de l'invention qui va suivre, en référence aux figures annexées sur lesquelles :
- la figure 1 représente les différentes étapes d'un exemple de méthode de prélèvement de couche ;
- la figure 2 représente le résidu obtenu après le prélèvement de couche ;
- la figure 3 représente les différentes étapes d'un premier mode de réalisation selon l'invention ;
- la figure 4 représente les différentes étapes d'un deuxième mode de réalisation selon l'invention ;

### DESCRIPTION DETAILLEE DE L'INVENTION

Par souci de simplification de la description à venir, les mêmes références sont utilisées pour des éléments identiques ou assurant la même fonction dans l'état de la technique.

Les figures sont des représentations schématiques qui, dans un objectif de lisibilité, ne sont pas à l'échelle.

L'invention concerne un procédé de préparation du résidu d'un substrat donneur pour le rendre utilisable.

Ce résidu est obtenu suite au prélèvement, dans le substrat donneur 1, d'une couche mince 5 par délamination au niveau d'un plan fragilisé 3 par implantation ionique, le résidu 1' comprenant sur une face principale 10 une marche annulaire 11 correspondant à une partie non prélevée du substrat donneur 1. La couche mince 5 est transférée sur un substrat support 4.

Le substrat donneur 1 et le substrat support 4 peuvent être constitués de matériaux quelconques. Il peut s'agir d'un matériau semi-conducteur (tel que du silicium, du SiGe, du germanium, du nitrure de galium), d'un isolant (tel que du saphir ou du verre) ou d'un matériau piézoélectrique (tel que du tantalate de lithium ou le niobate de lithium).

Le substrat donneur 1 et/ou le substrat support 4 peuvent être munis d'une couche d'isolant superficielle 2 comprenant par exemple un oxyde de silicium ou d'aluminium ou un nitrure de silicium ou d'aluminium. Elle peut alors avoir été formée par dépôt, par oxydation ou par nitruration, selon le cas.

Le substrat support 1 et le substrat support 4 peuvent, de façon avantageuse, être des plaquettes de silicium prenant la forme de disque dont le diamètre est typiquement de 200mm, 300mm voire même 450mm. L'une au moins de ces plaquettes peut présenter en surface une couche d'isolant, si bien qu'en fin de procédé on dispose d'une plaquette de silicium sur isolant. Mais l'invention n'est pas limitée à ces seuls matériaux, cette seule forme ou ces seules dimensions.

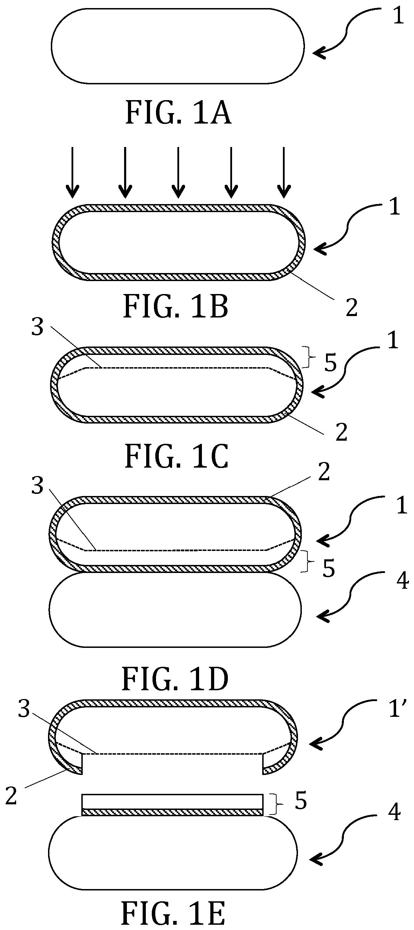

La figure 1 représente les différentes étapes d'un exemple de méthode de prélèvement de couche de type Smart Cut menant au résidu 1' utilisé par l'invention.

Ce type de méthode comprend la fourniture d'un substrat donneur 1, illustrée par la figure 1A, suivi, de manière optionnelle, d'une étape d'oxydation du substrat donneur 1 illustrée par la figure 1B avec la formation d'une couche d'oxyde superficielle 2 tel que décrit précédemment.

On effectue ensuite une première étape, illustrée par la figure 1C, de formation d'un plan fragilisé 3 par implantation d'espèces légères dans le substrat donneur 1 de manière à former une couche mince 5 entre ce plan et la surface implantée du substrat donneur 1. Le plan fragilisé 3 est typiquement réalisé par implantation d'hydrogène et/ou de gaz noble. Ainsi, les espèces légères peuvent être choisies parmi les ions d'hydrogène et d'hélium dans des doses comprises entre 5e15 et 1e17 at/cm². L'énergie d'implantation est quant à elle typiquement comprise entre 10keV et 200keV et définit la profondeur d'implantation des ions.

Dans une deuxième étape, illustrée par la figure 1D, postérieure à la première, le substrat support 4 est assemblé avec la surface implantée du substrat donneur 1, pour constituer un ensemble à fracturer. Cet assemblage est préférentiellement réalisé par adhésion moléculaire, c'est à dire par adhésion directe des surfaces entres elles sans ajout de matière adhésive (hormis de l'eau), et mettant en œuvre des forces d'adhésion principalement de type van der Waals ou covalentes.

L'étape d'assemblage peut être précédée de tout traitement de surface du substrat 1 et du support 4 préalable tel qu'un ou plusieurs nettoyages, une activation plasma...

Dans une étape suivante, illustrée par la figure 1E, l'ensemble à fracturer est soumis à une étape de traitement thermique de fracture. Cette étape vise à développer des microcavités, des platelets et/ou d'autres types de défauts précurseurs de la fracture au niveau du plan fragilisé 3. Elle conduit à l'initiation et à la propagation de l'onde de fracture le long du plan fragilisé 3 de manière à reporter la couche mince 5 sur le substrat support 4.

Ce traitement thermique de fracture peut également contribuer à renforcer le degré d'adhésion entre le substrat donneur 1 et le substrat support 4.

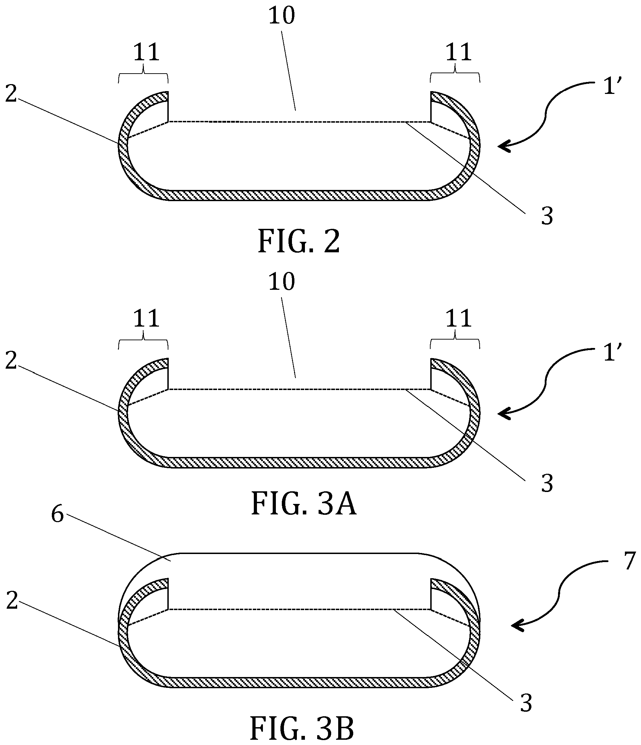

A l'issue de cette étape de traitement thermique de fracture, et comme représenté sur la figure 1E, on dispose donc, d'une part, de la couche mince 5 reportée sur le support 4, et d'autre part d'un résidu 1', représenté plus en détail sur la figure 2, du substrat donneur 1 d'où a été prélevée la couche utile 5.

Le résidu 1' comprend, sur une face principale 10, une marche annulaire 11 correspondant à une partie non prélevée du substrat donneur 1. Il s'agit d'une zone périphérique où le degré d'adhésion entre le substrat donneur 1 et le substrat support 4 est insuffisant pour permettre le prélèvement de la couche. La largeur de la marche 11 peut aller de 0,5 à 3 mm et sa hauteur peut aller de 100 nm à 3,5 micromètres, voire 4 micromètres.

La présence de la marche 11, et les propriétés de surface de la face principale 10 ne permettent pas une réutilisation directe et nécessitent la préparation du résidu 1' avant une nouvelle utilisation, notamment dans un procédé de type Smart Cut^{™} ou de transfert de couche. La présente invention propose une telle préparation du résidu 1'.

### Premier mode de réalisation

Selon un premier mode de réalisation, représenté sur les figures 3A et 3B, le procédé de préparation du résidu 1' comprend deux étapes : un dépôt d'un oxyde lissant 6 sur la face principale 10 du résidu 1' et un traitement thermique de densification de l'oxyde lissant.

L'oxyde lissant 6 est généralement choisi parmi la famille des SOG (du terme anglo-saxon « Spin On Glass » signifiant verre déposable par centrifugation) qui ont la propriété d'être à l'état liquide à température ambiante mais peuvent se densifier, et être rendus solides, grâce à un traitement thermique approprié.

L'étape de dépôt de l'oxyde lissant 6 consiste à déposer une couche d'oxyde lissant 6 sur la face principale 10 du résidu 1', pour combler l'espace interne défini par la marche annulaire 11 et recouvrir au moins en partie la marche annulaire 11. Le dépôt de l'oxyde lissant 6 peut aussi, de manière préférée, être réalisé dans des conditions conduisant à former une couche présentant une épaisseur au moins égale à une fois et demie la hauteur de la marche annulaire 11 comme cela est illustré sur la figure 3B. Afin de réaliser la planarisation de la surface principale 10 par l'oxyde lissant 6, le résidu 1' est mis en rotation sur son support afin de pouvoir se répartir par effet centrifuge.

L'étape de traitement thermique de densification consiste à exposer le résidu muni de la couche d'oxyde lissant 6 à une température comprise entre 225 et 850°C, voire 900°C. Ce traitement thermique peut durer environ 1h et peut être effectué sous une atmosphère d'azote.

A l'issue de cette étape, la surface de l'oxyde lissant 6 est suffisamment lisse, avec une rugosité typiquement inférieure à 5Å RMS (mesure AFM 5×5µm²), pour satisfaire les besoins de son utilisation ultérieure. La couche d'oxyde lissant 6 possède une élasticité, une viscosité et/ou une résistance à la rupture suffisantes pour prévenir l'éventuelle exfoliation des bulles liées au plan fragilisé existant sous la marche 11, au cours du recuit de densification ou lors d'étapes conduisant à exposer le substrat traité à des température élevées.

A l'issue de ces traitements on dispose d'un substrat 7, illustré par la figure 3B, comprenant un résidu 1' d'un substrat donneur 1, le résidu 1' comprenant sur une face principale 10 une marche annulaire 11 correspondant à une partie non prélevée du substrat donneur 1. Le résidu 1' peut aussi comprendre une couche d'oxyde superficielle 2 obtenue lors des étapes de transfert de la couche mince 5 du substrat donneur 1 vers le substrat support 4. Le substrat donneur 1 peut être constitué de silicium.

Le substrat 7 comprend aussi une couche d'oxyde 6 sur la face principale 10 du résidu 1', la couche d'oxyde 6 comblant l'espace interne défini par la marche annulaire 11 et recouvrant au moins en partie la marche annulaire 11. De manière préférée, la couche d'oxyde 6 présente une épaisseur au moins égale à une fois et demie la hauteur de la marche annulaire 11.

### Deuxième mode de réalisation

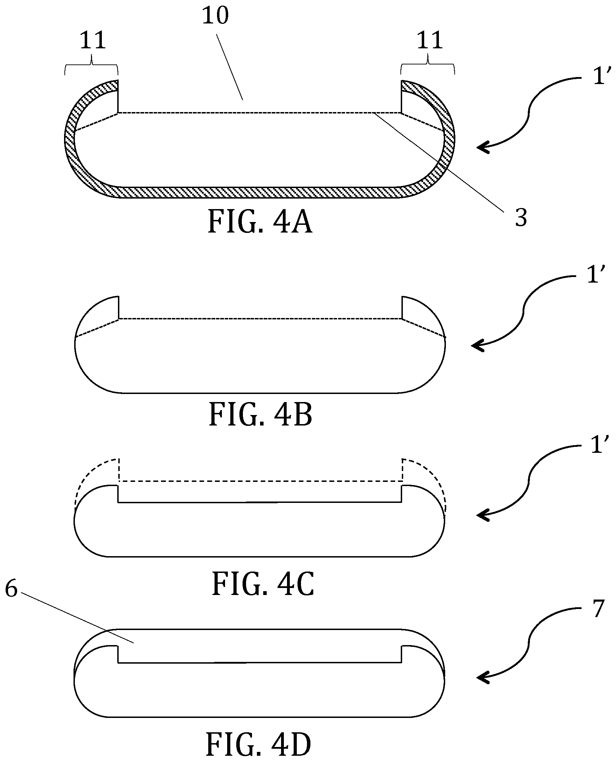

Selon un deuxième mode de réalisation, représenté sur les figures 4A à 4D, le procédé de préparation du résidu 1' comprend une étape additionnelle de préparation de la surface principale 10 du résidu 1' avant l'étape de dépôt de l'oxyde lissant 6.

En effet, il existe un risque d'exfoliation de la marche annulaire 11, ou d'une partie de celle-ci, au niveau des défauts d'implantation résiduels, lorsque ceux-ci restent présents dans le résidu 1' tel que cela est visible sur les figures 3A et 4A. Ce problème peut se produire avec le premier mode de réalisation même s'il demeure avantageusement réduit par le recouvrement de la marche 11 avec l'oxyde lissant 6, grâce notamment à ses propriétés de viscosité, d'élasticité et de résistance à la rupture. Toutefois il reste possible de réduire d'avantage ce risque.

Afin de réduire ce risque, ce second mode de mise en œuvre prévoit une étape de préparation de la surface principale 10 du résidu visant à éliminer la partie de la marche 11 sujette à l'exfoliation. Cette étape de préparation de la surface principale 10 du résidu 1' peut ainsi comprendre :
- le retrait préliminaire de la couche d'oxyde superficielle 2 (figure 4B);
- une élimination de matière, par exemple par gravure chimique, configurée pour retirer une fine couche de la surface principale 10 du résidu 1' et éliminer la partie endommagée de la marche 11 par l'implantation ionique (figure 4C). Autrement dit, l'étape de préparation de la surface principale 10 comprend le retrait d'une zone périphérique de cette surface, qui a été endommagée par l'implantation ionique.

L'étape de retrait de la couche d'oxyde, représentée par la figure 4B, permet d'exposer la partie endommagée de la marche 11 que l'on souhaite traiter. Il peut s'agir par exemple d'une gravure chimique humide à froid de l'oxyde avec une solution diluée d'acide fluorhydrique (HF).

L'étape de gravure chimique du résidu permet le retrait de la partie de la marche 11 endommagée par l'implantation ionique et donc sujette à l'exfoliation. Il peut s'agir par exemple d'une gravure chimique humide à chaud du résidu 1' par une solution aqueuse basique de TMAH ou de KOH pour retirer une épaisseur du résidu 1' sur une profondeur au moins équivalente à la hauteur de la marche initiale.

Il est aussi possible d'envisager d'autres méthodes pour préparer la surface telles qu'un polissage et/ou un détourage partiel de bord de plaque par exemple.

Cette étape de préparation de la surface met en œuvre des traitements simples et peu onéreux, qui ne permettent toutefois pas d'obtenir une surface parfaitement plane. A l'issue de ces traitements, et quelle que soit la technologie mise en œuvre au cours de l'étape de préparation de surface, le résidu 1 présente toujours une topologie périphérique définissant une marche annulaire 11 résiduelle.

A la suite de l'étape de préparation de surface, on reproduit les étapes décrites en relation avec le premier mode de mise en œuvre, c'est à dire que l'on dépose l'oxyde lissant sur la face principale 10 du résidu pour combler l'espace interne défini par la marche annulaire 11 et recouvrir au moins en partie la marche annulaire 11 ; et que l'on applique un traitement thermique de densification de l'oxyde lissant 6.

A l'issue de ce procédé on dispose d'un substrat 7, illustré par la figure 4D, comprenant un résidu 1' du substrat donneur 1, comprenant sur sa face principale 10 une marche annulaire 11 résiduelle. Le résidu 1' peut aussi comprendre une couche d'oxyde superficielle 2 (figure 3B). Le substrat 7 comprend aussi une couche d'oxyde 6 sur la face principale 10 du résidu 1', la couche d'oxyde 6 comblant l'espace interne défini par la marche annulaire 11 et recouvrant au moins en partie la marche annulaire 11.

Un procédé conforme à l'invention présente l'avantage, de réduire la perte de matière, de ne pas nécessiter le retrait complet de la marche 11 de la face principale 10 du résidu 1, et de fournir une face parfaitement plane. On peut notamment se dispenser d'une étape de « double-sided polishing », qui est généralement nécessaire dans les solutions de l'état de la technique. Il permet de préparer un résidu 7 en un nombre restreint d'étapes, en réduisant la perte de matière, et possédant des propriétés de surface suffisantes pour être employé, par exemple, en tant que substrat receveur pour la fabrication de substrats pour MEMS.

### Utilisation

Le substrat 7 obtenu à l'issue d'un procédé conforme à l'invention est utilisé comme substrat receveur pour la fabrication d'un substrat sur isolant, par exemple du type SOI.

L'utilisation de ce substrat 7 comprend son assemblage avec un substrat donneur puis l'amincissement de ce substrat donneur pour former une structure sur isolant.

Les propriétés de la couche d'oxyde lissant 6, permettent de réaliser l'assemblage sans appliquer de traitement thermique d'adhésion à haute température.

Le substrat 7 peut ainsi de manière préférée être utilisé comme support dans un procédé de report de couche, l'assemblage pouvant comprendre un traitement thermique pouvant se réaliser à basse température, typiquement entre 100°C et 900°C. De manière encore plus préférentielle, lesdits traitements thermiques sont réalisés à des températures comprises entre 100 et 500°C, et la couche transférée peut alors être munie de dispositifs microélectroniques pour une application dans le domaine de l'intégration 3D.

## Revendications

1. Procédé de préparation du résidu (1') d'un substrat donneur (1), le substrat donneur (1) ayant subi un prélèvement d'une couche (5) par délamination au niveau d'un plan fragilisé (3) par implantation ionique, le résidu (1') comprenant sur une face principale (10) une marche annulaire (11) correspondant à une partie non prélevée du substrat donneur, le procédé comprenant :
a. un dépôt d'un oxyde lissant (6) sur la face principale du résidu (10) pour combler l'espace interne défini par la marche annulaire (11) ;
b. un traitement thermique de densification de l'oxyde lissant (6) ;
le procédé étant **caractérisé en ce que** le dépôt de l'oxyde lissant (6) recouvre au moins en partie la marche annulaire (11).

2. Procédé de préparation selon la revendication précédente, dans lequel l'oxyde lissant (6) appartient à la famille des SOG (Spin On Glass).

3. Procédé de préparation selon l'une des revendications précédentes, dans lequel le traitement thermique de densification présente une température comprise entre 225 et 900 °C.

4. Procédé de préparation selon l'une des revendications précédentes, dans lequel le traitement thermique de densification est réalisé sous une atmosphère d'azote (N2) .

5. Procédé de préparation selon la revendication précédente, dans lequel le dépôt d'oxyde lissant (6) est réalisé dans des conditions conduisant à former une couche présentant une épaisseur au moins égale à une fois et demie la hauteur de la marche annulaire (11).

6. Procédé de préparation selon l'une des revendications précédentes comprenant, avant l'étape de dépôt, une étape de préparation de la surface principale (10) du résidu (1') comprenant le retrait d'une zone périphérique de la surface principale (là) endommagée par l'implantation ionique.

7. Substrat (7) comprenant :
a. un résidu (1') d'un substrat donneur (1), le substrat donneur (1) ayant subi un prélèvement d'une couche (5) par délamination au niveau d'un plan fragilisé (3) par implantation ionique, le résidu (1') comprenant sur une face principale (10) une marche annulaire (11) correspondant à une partie non prélevée du substrat donneur (1);
b. une couche d'oxyde (6) sur la face principale du résidu (1'), la couche d'oxyde (6) comblant l'espace interne défini par la marche annulaire ;
le substrat étant **caractérisé en ce que** la couche d'oxyde (6) recouvre au moins en partie la marche annulaire du résidu.

8. Substrat (7) selon la revendication précédente dans lequel la couche d'oxyde présente une épaisseur au moins égale à une fois et demie la hauteur de la marche annulaire.

9. Substrat (7) selon l'une des deux revendications précédentes dans lequel le résidu (1') comprend une couche d'oxyde superficielle (2).

10. Substrat (7) selon l'une des revendications 7 à 9 dans lequel le substrat donneur (1) est constitué de silicium.

11. Utilisation d'un substrat (7), comprenant :
a. La fourniture d'un substrat (7) conforme à l'une des revendications 7 à 10 ;
b. L'assemblage du substrat (7) avec un substrat donneur ;
c. L'amincissement du substrat donneur pour former une structure sur isolant.

12. Utilisation d'un substrat (7) selon la revendication précédente dans lequel l'assemblage comprend un traitement thermique à une température comprise entre 100°C et 500°C.

## Patentansprüche

1. Verfahren zur Vorbereitung des Rückstands (1') eines Donorsubstrats (1), wobei das Donorsubstrat (1) einer Entnahme einer Schicht (5) durch Delamination im Bereich einer durch lonenimplantation geschwächten Ebene (3) unterzogen wurde, wobei der Rückstand (1') auf einer Hauptfläche (10) eine ringförmige Stufe (11) umfasst, die einem Teil entspricht, der von dem Donorsubstrat nicht entnommen wurde, wobei das Verfahren umfasst:
a. eine Abscheidung eines Glättungsoxids (6) auf der Hauptfläche des Rückstands (10), um den Innenraum zu füllen, den die ringförmige Stufe (11) definiert;
b. eine Wärmebehandlung zum Verdichten des Glättungsoxids (6);
wobei das Verfahren **dadurch gekennzeichnet ist, dass** die Abscheidung des Glättungsoxids (6) die ringförmige Stufe (11) mindestens zum Teil bedeckt.

2. Verfahren zur Vorbereitung nach dem vorstehenden Anspruch, wobei das Glättungsoxid (6) zu der Familie der SOG (Spin On Glass) gehört.

3. Verfahren zur Vorbereitung nach einem der vorstehenden Ansprüche, wobei die Wärmebehandlung zur Verdichtung eine Temperatur zwischen 225 und 900 °C aufweist.

4. Verfahren zur Vorbereitung nach einem der vorstehenden Ansprüche, wobei die Wärmebehandlung zur Verdichtung unter einer Stickstoffatmosphäre (N2) ausgeführt wird.

5. Verfahren zur Vorbereitung nach dem vorstehenden Anspruch, wobei die Abscheidung des Glättungsoxids (6) unter Bedingungen ausgeführt wird, die dazu führen, eine Schicht zu bilden, die eine Dicke von mindestens gleich dem Eineinhalbfachen der Höhe der ringförmigen Stufe (11) aufweist.

6. Verfahren zur Vorbereitung nach einem der vorstehenden Ansprüche, das vor dem Abscheidungsschritt einen Vorbereitungsschritt der Hauptoberfläche (10) des Rückstands (1') umfasst, der das Beseitigen einer peripheren Zone der Hauptoberfläche (1à), die von der Ionenimplantation beschädigt wurde, umfasst.

7. Substrat (7), das umfasst:
a. einen Rückstand (1') eines Donorsubstrats (1), wobei das Donorsubstrat (1) einer Entnahme einer Schicht (5) durch Delamination im Bereich einer durch Ionenimplantation geschwächten Ebene (3) unterzogen wurde, wobei der Rückstand (1') auf einer Hauptfläche (10) eine ringförmige Stufe (11) umfasst, die einem Teil entspricht, der von dem Donorsubstrat (1) nicht entnommen wurde;
b. eine Oxidschicht (6) auf der Hauptfläche des Rückstands (1'), wobei die Oxidschicht (6) den Innenraum füllt, der von der ringförmigen Stufe definiert ist;
wobei das Substrat **dadurch gekennzeichnet ist, dass** die Oxidschicht (6) die ringförmige Stufe des Rückstands mindestens zum Teil bedeckt.

8. Substrat (7) nach dem vorstehenden Anspruch, wobei die Oxidschicht eine Dicke, die mindestens dem Eineinhalbfachen der Höhe der ringförmigen Stufe entspricht, aufweist.

9. Substrat (7) nach einem der beiden vorstehenden Ansprüche, wobei der Rückstand (1') eine oberflächliche Oxidschicht (2) umfasst.

10. Substrat (7) nach einem der Ansprüche 7 bis 9, wobei das Donorsubstrat (1) aus Silizium besteht.

11. Verwendung eines Substrats (7), die umfasst:
a. Bereitstellung eines Substrats (7) nach einem der Ansprüche 7 bis 10;
b. Zusammenfügen des Substrats (7) mit einem Donorsubstrat;
c. Verdünnung des Donorsubstrats, um eine Struktur auf dem Isolator zu bilden.

12. Verwendung eines Substrats (7) nach dem vorstehenden Anspruch, wobei das Zusammenfügen eine Wärmebehandlung bei einer Temperatur zwischen 100 °C und 500 °C umfasst.

## Claims

1. Method for preparing a residue (1') of a donor substrate (1), a layer (5) of the donor substrate (1) having been removed by delamination in a plane (3) weakened by ion implantation, the residue (1') comprising, on a main surface (10), an annular step (11) corresponding to a non-removed part of the donor substrate, the method comprising:
a. depositing a smoothing oxide (6) on the main surface of the residue (10) to fill the internal space defined by the annular step (11);
b. a heat treatment for densifying the smoothing oxide (6);
the method being **characterized in that** the deposit of the smoothing oxide (6) at least partially covers the annular step (11).

2. Preparation method according to the preceding claim, wherein the smoothing oxide (6) belongs to the SOG (spin-on glass) family.

3. Preparation method according to any of the preceding claims, wherein the thermal densification treatment has a temperature of between 225 and 900°C.

4. Preparation method according to any of the preceding claims, wherein the thermal densification treatment is carried out under a nitrogen (N2) atmosphere.

5. Preparation method according to the preceding claim, wherein the deposition of smoothing oxide (6) is carried out under conditions resulting in the formation of a layer having a thickness at least equal to one and a half times the height of the annular step (11).

6. Preparation method according to any of the preceding claims, comprising, before the deposition step, a step for preparing the main surface (10) of the residue (1') comprising the removal of a peripheral zone of the main surface (1à) damaged by ion implantation.

7. Substrate (7), comprising:
a. a residue (1') of a donor substrate (1), a layer (5) of the donor substrate (1) having been removed by delamination in a plane (3) weakened by ion implantation, the residue (1') comprising, on a main surface (10), an annular step (11) corresponding to a non-removed part of the donor substrate (1);
b. an oxide layer (6) on the main surface of the residue (1'), the oxide layer (6) filling the internal space defined by the annular step;
the substrate being **characterized in that** the oxide layer (6) at least partially covers the annular step of the residue.

8. Substrate (7) according to the preceding claim, wherein the oxide layer has a thickness at least equal to one and a half times the height of the annular step.

9. Substrate (7) according to one of the two preceding claims, wherein the residue (1') comprises a surface oxide layer (2).

10. Substrate (7) according to any of claims 7 to 9, wherein the donor substrate (1) consists of silicon.

11. Use of a substrate (7), comprising:
a. providing a substrate (7) according to any of claims 7 to 10;
b. assembling the substrate (7) with a donor substrate;
c. thinning the donor substrate to form a structure on insulator.

12. Use of a substrate (7) according to the preceding claim, wherein the assembly comprises a heat treatment at a temperature between 100°C and 500°C.
